# DEMANDE DE BREVET EUROPEEN

(11) **EP 0 811 884 A1**
(43) Date de publication de la demande: **10.12.1997**
(21) Numéro de dépôt: 96470008.2
(22) Date de dépôt: 04.06.1996
(51) Int. Cl.: G03F 7/30

(54) **Brosse circulaire plane pour machines à graver des plaques photopolymères**

(71) Demandeur: PHOTOMECA S.A. / EGG, 54340 Pompey (FR)
(72) Inventeur: Ferrante, Mario, 54520 Laxou (FR)
(74) Mandataire: Poupon, Michel

(57) **Abrégé**

L'invention concerne un poste de gravure pour machine à graver des clichés d'impression à partir d'une plaque photopolymère pour la flexographie, la typographie ou l'offset sec, caractérisé en ce qu'il comporte une brosse (5) de gravure plane et circulaire, montée à rotation autour de son axe central, et des rouleaux presseurs (6) horizontaux maintenant la plaque (14) pendant l'opération de gravure.

## Description

La présente invention concerne une brosse de machine à graver et une machine à graver pour la réalisation d'imprimés en flexographie, typographie ou offset sec.

Les clichés pour la flexographie ou la typographie sont obtenus en exposant une plaque de photopolymère sensible aux rayonnements ultraviolets, avec interposition d'un film négatif qui laisse exposées au rayonnement les zones qui doivent venir en relief sur le cliché terminé.

Le rayonnement durcit ces zones, on élimine ensuite la matière de la surface protégée en la brossant à l'aide de brosses planes ou rotatives ou par buses de pulvérisation ; un solvant ou de l'eau faisant office d'agent mouillant, on poursuit l'opération jusqu'à ce que les zones qui ont été exposées se trouvent suffisamment en relief.

Un premier objet de l'invention est d'automatiser complètement l'ensemble du procédé de gravure.

Par ailleurs, on trouve actuellement sur le marché une large gamme de plaques photopolymères de toutes épaisseurs et dans tous les formats (jusqu'à 50 x 80 pouces- et on fabrique déjà des machines semi-automatiques ou automatiques sur lesquelles le cliché photopolymère est fixé ou collé sur le plateau porte-cliché et une brosse plane à mouvement orbital baignant dans un bain de gravure, permet de confectionner des clichés.

Un autre but de l'invention est donc de confectionner des clichés photopolymères de tous formats et épaisseurs, dans une machine simple, permettant d'introduire d'un coté un cliché déjà exposé et de récupérer celui-ci après gravure, presque sec, dans un minimum de temps.

Une machine de ce type est décrite dans le brevet 2 697 354 de la demanderesse. Cette machine présente de bonnes performances de gravures et permet de graver en une seule fois des clichés de grand format.

La présente invention vise à simplifier et diminuer le coût des petites machines à graver, les clichés de petits formats.

Jusqu'à présent, on utilisait des brosses rotatives cylindriques tournant autour de l'axe du cylindre disposé horizontalement, ou bien des brosses planes à mouvement linéaire et alternatif. Dans les deux cas, les surfaces brossées sont des surfaces rectangulaires permettant une gravure régulière sur toute la surface rectangulaire du cliché.

Dans l'invention, on est allé à l'encontre des idées reçues en employant une brosse rotative à axe vertical dont la surface de brossage est circulaire.

Il a fallu alors résoudre le problème des déplacements latéraux de la plaque pendant la gravure. Ce problème est résolu grâce au poste de gravure pour machine à graver des clichés d'impression à partir d'une plaque photopolymère pour la flexographie, la typographie ou l'offset sec, caractérisé en ce qu'il comporte une brosse de gravure pla Ne et circulaire, montée à rotation autour de son axe central, et des rouleaux presseurs horizontaux maintenant la plaque pendant l'opération de gravure.

Selon un mode préférentiel de mise en oeuvre et pour palier au problème des irrégularités de brossage, la brosse est entraînée alternativement dans un sens et dans l'autre.

Dans toute la suite du texte et dans les revendications, on comprendra que le terme de solvant signifie qu'on peut utiliser tout solvant de gravure, de l'eau, ou un pourcentage d'acide ou de base.

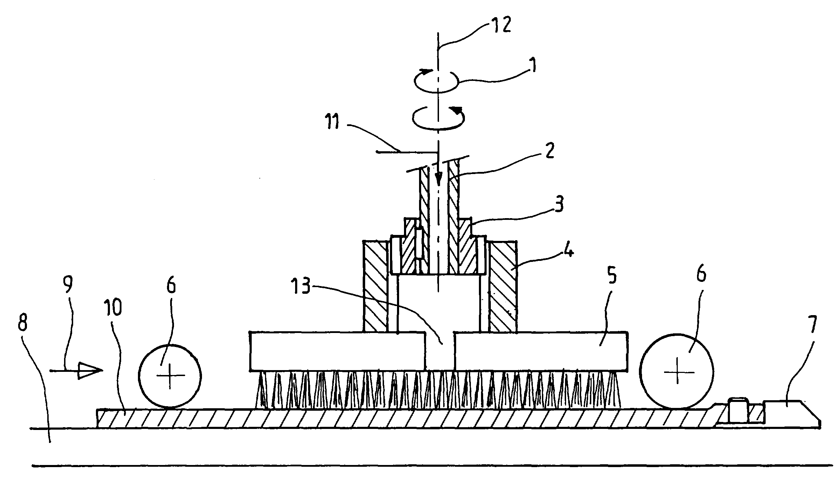

On comprendra mieux l'invention à l'aide de la description qui suit faite en référence à la figure unique annexée qui représente en coupe verticale une brosse selon l'invention.

Une brosse circulaire (5) est montée à rotation autour de son axe de symétrie (12) disposé verticalement.

Elle est entraînée à rotation par un moteur-réducteur non représenté entraînant l'axe vertical creux (2) dont l'alésage central (11) permet l'arrivée du solvant dans la brosse (5). Le mouvement est transmis à la brosse par un système à cardan moleté (3) combiné à un fourreau cranté (4) solidaire de la brosse (5); le fourreau (4) est également creux pour le passage du solvant à travers un perçage central (13) de la brosse. Tout autre moyen de liaison mécanique entre la brosse (5) et le moteur-réducteur et/ou tout autre moyen d'amenée du solvant peuvent convenir.

Une plaque à graver (10) est amenée en position de gravure par une barre de gravure (7) et supportée par une table de base (8). Deux ou plusieurs rouleaux presseurs (6) libres en rotation autour de leur axe horizontal, sont placés respectivement devant et derrière la brosse (5) par rapport au sens de déplacement (9) de la plaque (14). Leur fonction est d'empêcher les déplacements latéraux de la plaque pendant la gravure.

Afin de rattraper les défauts de gravure, la brosse est entraînée alternativement dans un sens et dans l'autre selon les flèches (1).

On prévoit en outre sous la brosse et du côté des poils, ou bien dans la brosse elle-même, des moyens de répartition du solvant sur la surface de gravure, par exemple des rainures radiales et/ou des trous.

En outre la brosse est libre en hauteur de façon à s'adapter à l'épaisseur de la plaque.

Le poste de gravure selon l'invention est suivi de façon classique par un poste de rinçage classique.

L'invention permet la réalisation de machines à graver de petites dimensions, simples, peu onéreuses dont les performances de gravures sont satisfaisantes pour des clichés de petits formats.

Ces machines peuvent fonctionner en continu ce qui est nouveau sur le marché.

## Revendications

1. Poste de gravure pour machine à graver des clichés d'impression à partir d'une plaque photopolymère pour la flexographie, la typographie ou l'offset sec, caractérisé en ce qu'il comporte une brosse (5) de gravure plane et circulaire, montée à rotation autour de son axe central, et des rouleaux presseurs (6) horizontaux maintenant la plaque (14) pendant l'opération de gravure.

2. Poste de gravure selon la revendication précédente, caractérisé en ce que la brosse de gravure (5) est entraînée à rotation par un axe creux (2), un système à cardan moleté (3) combiné à un fourreau cranté (4) solidaire de la brosse (5).

3. Poste de gravure selon la revendication précédente, caractérisé en ce que l'ensemble axe (2), fourreau (4) sont creux pour le passage du solvant à travers un perçage central (13) de la brosse.

4. Poste de gravure selon la revendication principale, caractérisé en ce que les rouleaux presseurs (6) sont disposés devant et derrière la brosse par rapport au sens de déplacement de la plaque.

5. Poste de gravure selon la revendication précédente, caractérisé en ce que les rouleaux presseurs sont au nombre de deux.

6. Poste de gravure selon la revendication 3, caractérisé en ce que la brosse comporte en outre des moyens de répartition du solvant.

7. Poste de gravure selon la revendication précédente, caractérisé en ce que les moyens de répartition du solvant sont choisis dans l'ensemble (trou, rainures radiales).

8. Poste de gravure selon l'une des revendications précédentes, caractérisé en ce que la brosse est libre en hauteur.

9. Poste de gravure selon l'une des revendications 1 à 8, caractérisé en ce que la brosse est entraînée alternativement dans un sens et dans l'autre.

10. Machine de gravure, caractérisée en ce qu'elle comporte un poste de gravure à brosse circulaire selon l'une quelconque des revendications 1 à 9.
